(19) Europäisches Patentamt
European Patent Office
Office européen des brevets

(11) **EP 1 840 583 A1**

(12) **EUROPEAN PATENT APPLICATION**
published in accordance with Art. 158(3) EPC

(43) Date of publication:
**03.10.2007 Bulletin 2007/40**

(51) Int Cl.:
*G01R 27/02* (2006.01)

(21) Application number: **06711756.4**

(22) Date of filing: **17.01.2006**

(86) International application number:
**PCT/JP2006/300476**

(87) International publication number:
**WO 2006/075750 (20.07.2006 Gazette 2006/29)**

(84) Designated Contracting States:
**DE FR IT**

(30) Priority: **17.01.2005 JP 2005009482**

(71) Applicant: **TOHOKU UNIVERSITY**
**Aoba-ku**
**Sendai-shi, Miyagi 980-8577 (JP)**

(72) Inventors:
• **OHMI, Tadahiro**
**c/o TOHOKU UNIVERSITY**
**Miyagi, 980-8577 (JP)**

• **TERAMOTO, Akinobu**
**c/o TOHOKU UNIVERSITY**
**Miyagi, 980-8577 (JP)**

(74) Representative: **Glawe, Delfs, Moll**
**Patentanwälte**
**Postfach 26 01 62**
**80058 München (DE)**

(54) **ELECTRONIC DEVICE MEASURING METHOD AND ELECTRONIC DEVICE MEASURING APPARATUS**

(57) In a method for measuring an electronic device which is an object to be measured, a passive element is connected to the electronic device in parallel, and electric parameters of the electronic device are extracted by measuring an impedance of the entire circuit.

[Fig. 1]

EP 1 840 583 A1

**Description**

Technical Field

This invention relates to a measuring method and apparatus for extracting an electrical parameter of an electronic device such as a semiconductor device.

Background Art

Conventionally, the capacitance, inductance, and resistance of an electronic device are measured at a measurement frequency of about 100Hz to 1 MHz using an auto-balancing bridge method (see Noritoku Ohura and Matsuo Sekine, "ELECTRICAL- ELECTRONIC MEASUREMENT", Shokodo Co., Ltd., p.106, March 10, 2002).

Disclosure of the Invention

Problem to be Solved by the Invention

However, the foregoing conventional technique has a problem that if the current passing through a measurement object increases, it is difficult to measure the capacitance component thereof.
Therefore, this invention has been made in view of the problem of the foregoing conventional technique and has an object to enable accurate measurement of an electrical parameter of a measurement object even in a measurement range where an excessive current flows in parallel.

Means for Solving the Problem

In order to achieve the aforementioned object, according to the present invention, in a method of measuring an electronic device as a measurement object; comprising: connecting a passive element in parallel with the electronic device, and measuring an impedance of an entire circuit to thereby extract an electrical parameter of the electronic device.
Further, according to the present invention, in a measuring apparatus for measuring an electronic device as a measurement object, wherein: a passive element is connected in parallel with the electronic device, and an electrical parameter of the electronic device is extracted by measuring an impedance of an entire circuit using an impedance measuring device connected between both terminals of the electronic device.
Herein, the passive element comprises an inductance and a resistance connected in series with the inductance. For example, the electrical parameter is an electrical capacitance.
The measurement is preferably performed by causing a resonance phenomenon. Further, a current which flows between the terminals is $7\mu A$ or more. For example, the electronic device is a semiconductor device.
As described above, in this invention, the known passive element is added to the electronic device as the measurement object, the impedance of the entire circuit is measured, and the electrical parameter of the measurement object is extracted from its equivalent circuit.

Effect of the Invention

According to this invention, it is possible to accurately measure an electrical parameter of a measurement object even in a measurement range where an excessive current flows in parallel.

Brief Description of the Drawings

[Fig. 1] A circuit diagram showing a measurement system according to this invention.
[Fig. 2] A diagram showing an equivalent circuit of a MOS capacitor.
[Fig. 3] A diagram showing a graph representing the measurement frequency dependence of impedance measured by the present measurement and the measurement frequency dependence of impedance derived by performing parameter fitting.
[Fig. 4] A diagram showing a graph representing the relationships between voltage and capacitance obtained by measuring a MOS capacitor having a gate insulating film with an insulating film thickness of 8.5nm according to the usual measuring method and the present measuring method.
[Fig. 5] A diagram showing a graph representing the relationships between voltage and capacitance obtained by measuring a MOS transistor having a gate insulating film with an insulating film thickness of 1.18nm according to the usual measuring method and the present measuring method.

[Fig. 6] A diagram showing current values when the voltage is applied to the MOS transistor having the gate insulating film with the insulating film thickness of 1.18nm.

[Fig. 7] A diagram showing the relationship between insulating film thickness derived by the usual method and insulating film thickness derived by the present measuring method.

Best Mode for Carrying Out the Invention

(First Embodiment)

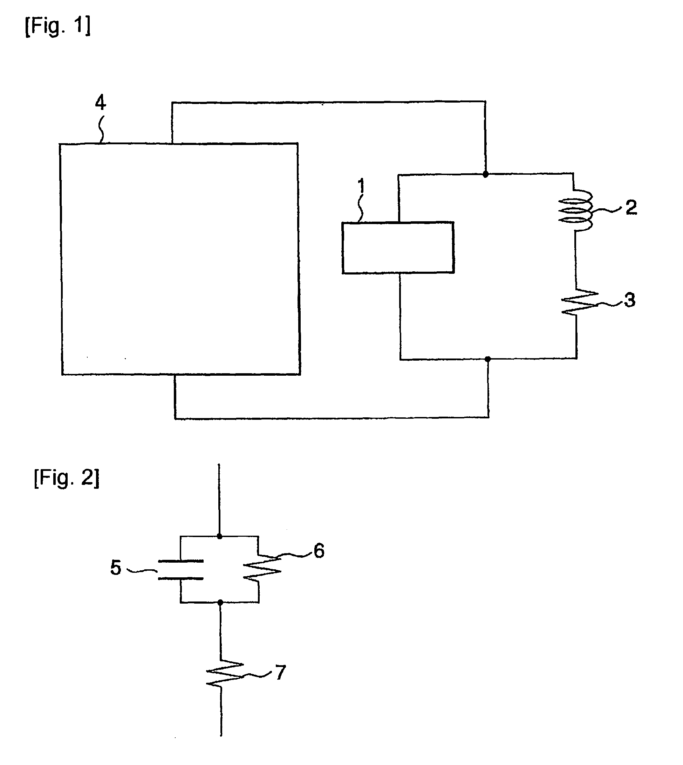

As shown in Fig. 1, an inductance (L) 2 and a resistance (R) 3 are added in parallel with a MOS capacitor 1 as a measurement object and both ends thereof are connected to an impedance measuring device 4.

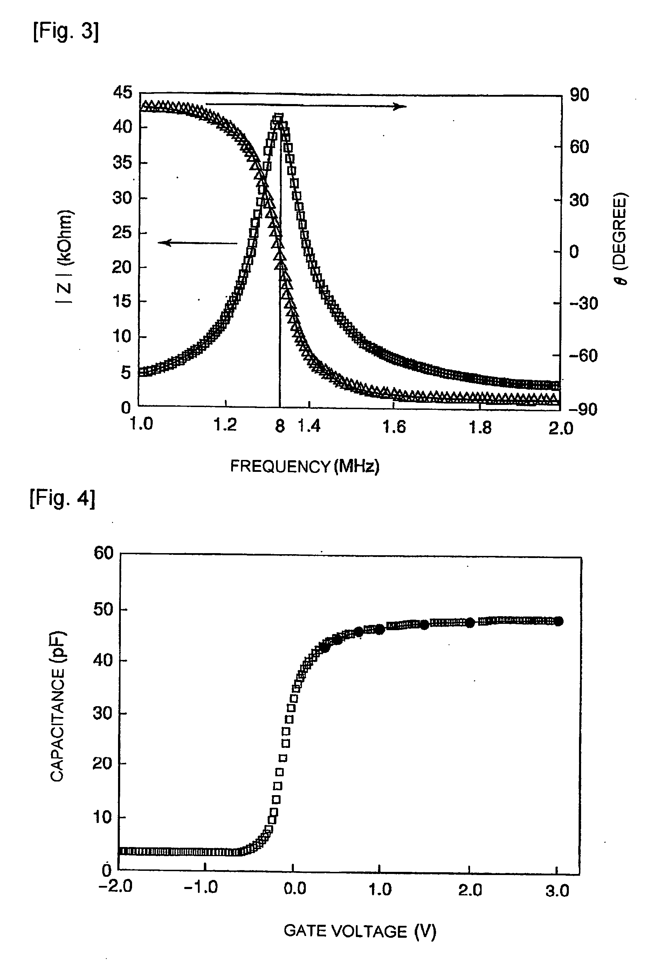

As shown in Fig. 2, an equivalent circuit of the MOS capacitor 1 can be expressed using a capacitance (Ci) 5, a parallel resistance (Rp) 6, and a series resistance (Rs) 7. Herein, an impedance Z1 of the MOS capacitor 1, an impedance Z2 of the added inductance 2 and resistance 3, and the total impedance Z are given by formulas 1, wherein $\omega$ represents a measurement frequency.

## [Formulas 1]

$$Z1 = \frac{Rp + Rs + j\omega CiRpRs}{1 + j\omega CiRp} \quad , \quad Z2 = R + j\omega L$$

$$Z = \frac{R(Rp + Rs) - \omega^2 LCiRpRs + j\omega\{CiRpRsR + L(Rp + Rs)\}}{Rp + Rs + R - \omega^2 LCiRp + j\omega\{L + CiRp(Rs + R)\}}$$

Further, a resonance frequency wr is given by formula 2.

## [Formula 2]

$$\omega_r = \sqrt{\frac{L(Rp + Rs)^2 - CiRp^2 R}{L^2 CiRp^2 + LCi^2 Rp^2 Rs^2}}$$

By selecting L (330$\mu$H) of the added inductance 2 and R (100$\Omega$) of the added resistance 3 so that wr becomes 2MHz or less, the inductance component of the measurement system is ignored. Herein, L of the added inductance 2 and R of the added resistance 3 may be selected for wr so that the inductance of the measurement system takes a value sufficiently smaller than Z.

When the frequency dependence of Z is measured in this state, there are obtained measured values given by $\square$ and $\triangle$ in Fig. 3. Using the foregoing formula at a resonance frequency point 8, Rp, Rs, and Ci are derived by numerical fitting. Curves shown in solid lines in Fig. 3 represent |Z| and $\omega$ at other frequencies calculated using the derived values.

Fig. 4 shows the relationship between capacitance and applied voltage derived therefrom and the relationship between capacitance and voltage derived by the usual auto-balancing bridge method.

What are indicated by black squares are derived by the usual method and what are indicated by • are derived by the present measuring method. The insulating film thickness of the MOS capacitor derived from Ci thus obtained is 8.5nm.

(Second Embodiment)

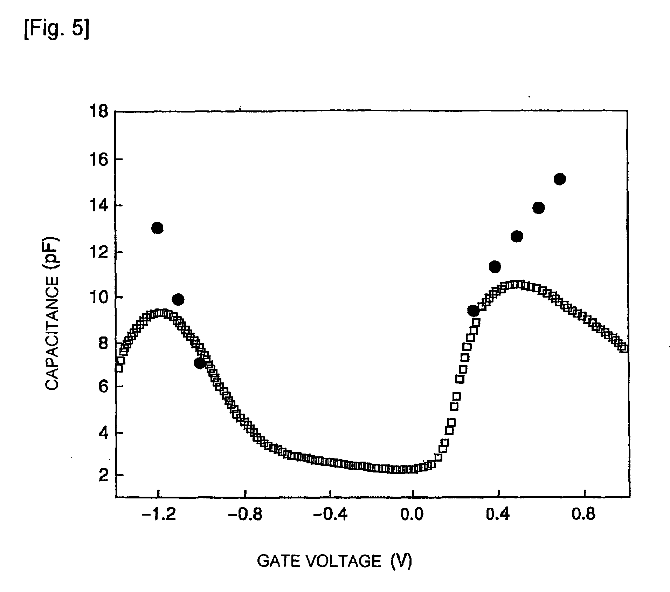

A MOS transistor having a gate insulating film thickness of about 1.18nm is measured in the same manner as in the first embodiment. L of an added inductance 2 and R of an added resistance 3 are 33mH and 100Ω, respectively. Fig. 5 shows the relationship between capacitance and applied voltage thereupon and the relationship between capacitance and voltage derived by the usual auto-balancing bridge method.

What are indicated by black squares are derived by the usual method and what are indicated by • are derived by the present measuring method. Here, in the relationship between capacitance and voltage derived by the usual auto-balancing bridge method, the capacitance decreases where the voltage is large for both positive and negative voltages.

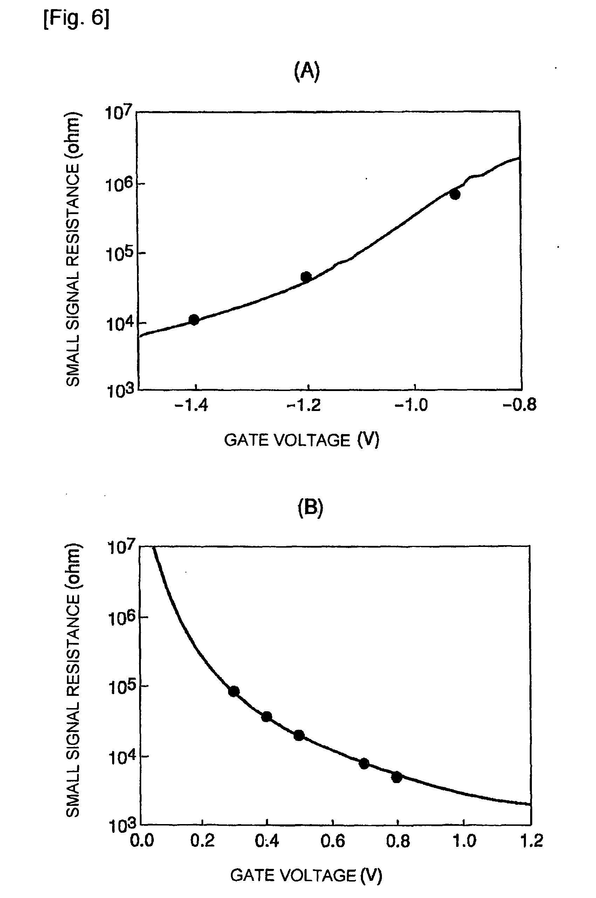

This is because, as shown in Fig. 6, (A) and (B), when the applied voltage increases, the capacitance cannot be accurately measured due to increase in current. When a current value becomes about 7μA or more, reduction in capacitance value is observed. On the other hand, when measured by the present measuring method, increase in capacitance is observed following increase in absolute value of voltage. Thus, it is understood that the measurement is accurately performed.

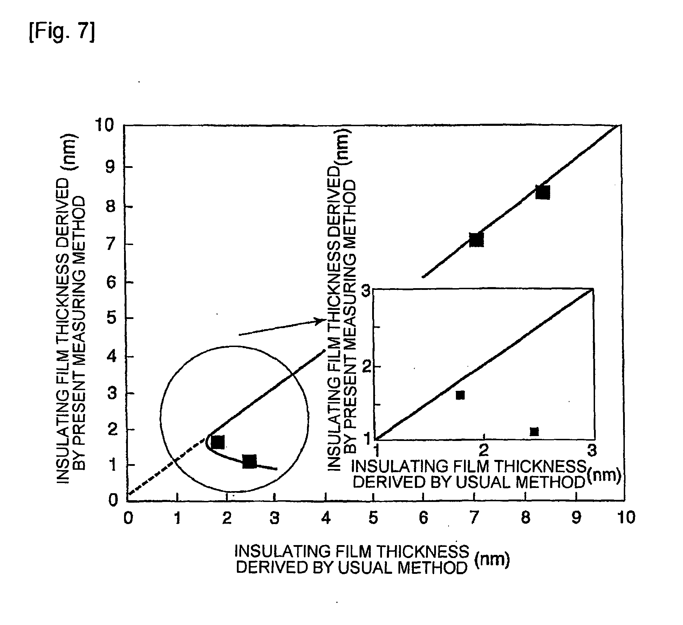

Fig. 7 shows the relationship between insulating film thickness derived by the usual method and insulating film thickness derived by the present measuring method.

According to the usual method, the measurement is not accurately performed in a thin film range (a range where an excessive current flows in a measurement range) so that the film thickness increases, while, according to the present measuring method, the measurement is accurately performed even in that range.

Industrial Applicability

According to this invention, an electrical parameter of a measurement object can be accurately measured even in a measurement range where an excessive current flows in parallel. As a result, the measuring method and the measuring apparatus of this invention are applicable to electronic devices such as semiconductor devices.

**Claims**

1. A method of measuring an electronic device as a measurement object; comprising:

   connecting a passive element in parallel with the electronic device, and
   measuring an impedance of an entire circuit to thereby extract an electrical parameter of the electronic device.

2. The method of measuring the electronic device according to claim 1, wherein:

   the passive element comprises an inductance and a resistance connected in series with the inductance.

3. The method of measuring the electronic device according to claim 1 or 2, wherein:

   the electrical parameter is an electrical capacitance.

4. The method of measuring the electronic device according to any one of claims 1 to 3, wherein:

   the measurement is performed by causing a resonance phenomenon.

5. The method of measuring the electronic device according to any one of claims 1 to 4, wherein:

   a current which flows between the terminals is 7μA or more.

6. The method of measuring the electronic device according to any one of claims 1 to 5, wherein:

   the electronic device is a semiconductor device.

7. A measuring apparatus for measuring an electronic device as a measurement object, wherein:

   a passive element is connected in parallel with the electronic device, and
   an electrical parameter of the electronic device is extracted by measuring an impedance of an entire circuit using an impedance measuring device connected between both terminals of the electronic device.

8. The measuring apparatus for measuring the electronic device according to claim 7, wherein:

   the passive element comprises an inductance and a resistance connected in series with the inductance.

9. The measuring apparatus for measuring the electronic device according to claim 7 or 8, wherein:

   the electrical parameter is an electrical capacitance.

10. The measuring apparatus for measuring the electronic device according to any one of claims 7 to 9, wherein:

    the measurement is performed by causing a resonance phenomenon.

11. The measuring apparatus for measuring the electronic device according to any one of claims 7 to 10, wherein:

    a current which flows between the terminals is $7\mu A$ or more.

12. The measuring apparatus for measuring the electronic device according to any one of claims 7 to 11, wherein:

    the electronic device is a semiconductor device.

[Fig. 1]

[Fig. 2]

[Fig. 3]

[Fig. 4]

[Fig. 5]

[Fig. 6]

(A)

(B)

[Fig. 7]

<div align="center">**INTERNATIONAL SEARCH REPORT**</div>

| | International application No. |
|---|---|
| | PCT/JP2006/300476 |

**A. CLASSIFICATION OF SUBJECT MATTER**
*G01R27/02*(2006.01)

According to International Patent Classification (IPC) or to both national classification and IPC

**B. FIELDS SEARCHED**

Minimum documentation searched (classification system followed by classification symbols)
*G01R27/00-27/32*(2006.01)

Documentation searched other than minimum documentation to the extent that such documents are included in the fields searched
Jitsuyo Shinan Koho 1922-1996 Jitsuyo Shinan Toroku Koho 1996-2006
Kokai Jitsuyo Shinan Koho 1971-2006 Toroku Jitsuyo Shinan Koho 1994-2006

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 61-209361 A (NEC Corp.), 17 September, 1986 (17.09.86), Full text; Figs. 1 to 2 (Family: none) | 1-12 |
| X | JP 8-278336 A (Murata Mfg. Co., Ltd.), 22 October, 1996 (22.10.96), Full text; Figs. 1 to 8 (Family: none) | 1-12 |
| X | JP 10-293137 A (Nikon Corp.), 04 November, 1998 (04.11.98), Full text; Figs. 1 to 10 (Family: none) | 1-12 |

☐ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 17 April, 2006 (17.04.06) | 25 April, 2006 (25.04.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

*   **NORITOKU OHURA ; MATSUO SEKINE.** ELEC-TRICAL- ELECTRONIC MEASUREMENT. Shokodo Co., Ltd, 10 March 2002, 106